# EUROPEAN PATENT APPLICATION

(11) **EP 3 306 363 A1**
(43) Date of publication of application: **11.04.2018**
(21) Application number: 16803181.3
(22) Date of filing: 26.05.2016
(51) Int. Cl.: G02B 5/20, B28B 11/14, H01L 33/50

(54) **METHOD FOR PRODUCING PHOSPHOR PLATE**

(30) Priority: 02.06.2015 JP 2015111873; 13.05.2016 JP 2016096805
(71) Applicant: Nitto Denko Corporation, Ibaraki-shi, Osaka 567-8680 (JP)
(72) Inventor: FUJII, Hironaka, Ibaraki-shi Osaka 567-8680 (JP); SHIRAKAWA, Masahiro, Ibaraki-shi Osaka 567-8680 (JP)
(74) Representative: Hoffmann Eitle
(86) International application number: PCT/JP2016/065528
(87) International publication number: WO 2016/194746

(57) **Abstract**

The method for producing a phosphor plate includes, in sequence, a step (1), in which a phosphor sheet is prepared, a step (2), in which through holes and penetration faces fronting the through holes are formed in the phosphor sheet, and a step (3), in which the phosphor sheet is cut to form a plurality of phosphor plates including the penetration faces.

## Description

### TECHNICAL FIELD

The present invention relates to a method for producing a phosphor plate, in particular, to a phosphor plate suitably used for an optical semiconductor device.

### BACKGROUND ART

Conventionally, it has been known that a luminescence conversion element including a ceramic material is used for an optoelectronic component along with a radiation-emitting semiconductor chip.

The luminescence conversion element is formed, for example, into a letter L shape plate having a cut portion (e.g., see Patent Document 1). Patent Document 1 has proposed an optoelectronic component in which the lower face of the luminescence conversion element is joined to the upper face of the radiation-emitting semiconductor chip, and the bonding pad provided in the corner region of the radiation-emitting semiconductor chip exposed from the cut portion is connected by a bonding wire.

Patent Document 1 has also proposed the following method as the method for producing a luminescence conversion element. That is, first, on the support, a partial shaped bodies composed of the luminescence conversion material is molded into a bar having a rectangular cross section and extending into front-back directions, then, the upper right corner portion viewed in cross section of the partial shaped bodies is ground along with front-back directions, and thereafter, the partial shaped bodies is cut along the orthogonal direction (up-down left-right directions) relative to front-back directions.

### Citation List

### Patent Document

Patent Document 1: Japanese Unexamined Patent Application Publication (Translation of PCT Application) 2014-502368

### SUMMARY OF THE INVENTION

### PROBLEM TO BE SOLVED BY THE INVENTION

However, with the method described in Patent Document 1, first, the bar shaped partial shaped bodies has to be molded, and therefore there are disadvantages in that production efficiency cannot be sufficiently improved.

Furthermore, with the method described in Patent Document 1, after the bar shaped partial shaped bodies is molded, and then thereafter the partial shaped bodies is ground along the front-back directions. Therefore, there are disadvantages in that the shape of the cutout portion is complicated.

An object of the present invention is to provide a method for producing a phosphor plate that is easy and excellent in production efficiency.

### MEANS FOR SOLVING THE PROBLEM

[1] present invention includes a method for producing a phosphor plate, the method including the steps in sequence of:
   a step (1), in which a phosphor sheet is prepared,
   a step (2), in which through holes and penetration faces fronting the through hole are formed in the phosphor sheet, and
   a step (3), in which the phosphor sheet is cut to form a plurality of phosphor plates including the penetration faces.

   With the method, without molding the bar-shaped shaped body as did in the method described in Patent Document 1, a phosphor sheet is prepared, and then, through holes are formed in the sheet, and thereafter, the sheet is cut. Therefore, the through holes are formed easily, and the phosphor plate can be produced with excellent production efficiency.
[2] The present invention includes a method for producing the phosphor plate of the above-described [1], wherein in the step (3), the phosphor sheet is cut so that the cutting line passes through the through holes, and by cutting the phosphor sheet, the penetration face is divided so that the penetration face defining one through hole is given to each of the plurality of phosphor plates.
   With the method, by cutting the phosphor sheet having the cutting lines, the penetration face defining one through hole is divided so that the penetration face is given to each of the plurality of phosphor plates, and therefore production efficiency is even more excellent.
[3] The present invention includes a method for producing the phosphor plate of the above-described [1] or [2], wherein
   in the step (1), the phosphor sheet is a greensheet containing phosphor, and
   a step (4), in which the phosphor sheet is a ceramic plate produced by calcining the greensheet, is further included after the step (2) and before the step (3).

   In this method, a phosphor sheet composed of the greensheet is produced, and a phosphor plate composed of a ceramics plate can be produced.
[4] The present invention includes a method for producing the phosphor plate of the above-described [3], further including, after the step (4) and before the step (3), a step (5) in which the ceramic plate is supported in a supporting sheet, and
   a step, in which after the step (3), the plurality of phosphor plates are transferred from the supporting sheet to the transfer sheet, and/or, a step (6), in which the plurality of phosphor plates are taken off from the supporting sheet, and the plurality of phosphor plates are arranged so that the penetration face are oriented toward the same direction, after the step (3).

   When the supporting sheet has scraps and/or cutting grooves caused by cutting, in later steps, the scrapes and/or cutting grooves may give effects.
   However, when a plurality of phosphor plates are transferred from the supporting sheet to the transfer sheet after the step (3) as in the present invention, the above-described effects can be excluded.
   Furthermore, after the step (3), by taking off the plurality of phosphor plates from the supporting sheet, and arranging the plurality of phosphor plates so that their penetration faces are directed to the same direction, handleability of the plurality of phosphor plates can be improved.
[5] The present invention includes a method for producing the phosphor plate of any one of the above-described [1] to [4], wherein in the step (3), at least one of the following methods are conducted: a method in which the phosphor sheet is cut with a cutting blade, a method in which the phosphor sheet is scribed and broken, a method in which the phosphor sheet is cut by laser, and a method in which the phosphor sheet is cut by blast processing.
   With the method, the phosphor sheet can be reliably cut.
[6] The present invention includes a method for producing the phosphor plate of any one of the above-described [1] to [5], wherein in the step (2), one of the following methods is conducted: a method in which the phosphor sheet is punched, a method in which the phosphor sheet is subjected to blast processing, a method in which the phosphor sheet is subjected to laser processing, and a method in which the phosphor sheet is subjected to drilling.
   With the method, the above-described method allows for reliable formation of the through hole in the phosphor sheet.
[7] The present invention includes the method for producing the phosphor plate of the above-described [1] or [2], wherein in the step (1), the phosphor sheet is a greensheet containing phosphor, and a step (4), in which the phosphor sheet is a ceramic plate produced by calcining the greensheet, is further included after the step (1) and before the step (2).
   In this method, the greensheet is a ceramic plate, and thereafter, through holes and penetration faces can be formed in a hard ceramic plate.
[8] includes the method for producing the phosphor plate of the above-described [7], wherein in the step (2), one of the following methods is conducted: a method in which the ceramic plate is subjected to blast processing, and a method in which the ceramic plate is subjected to laser processing.

In this method, through holes and penetration faces can be reliably formed in a hard ceramic plate.

### EFFECTS OF THE INVENTION

With the present invention, the through holes can be easily formed, and the phosphor plate can be produced with excellent production efficiency.

### BRIEF DESCRIPTION OF THE DRAWINGS

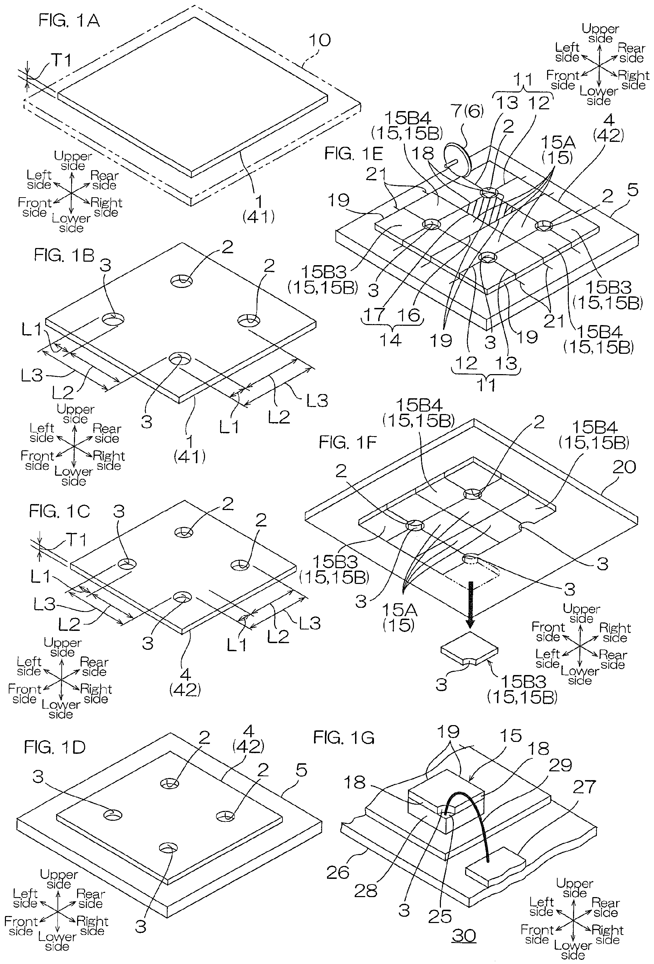

[FIG. 1] FIG. 1A to FIG. 1G are perspective views illustrating process diagrams showing an embodiment of the method for producing a phosphor plate of the present invention, and the method for producing an optical semiconductor device, FIG. 1A to FIG. 1E and FIG. 1G are perspective views from above, and FIG. 1F is a perspective view from below. FIG. 1A shows a step (1), in which a greensheet is prepared, FIG. 1B shows a step (2), in which through holes and penetration faces are formed in the greensheet, FIG. 1C shows a step (4), in which the greensheet is calcined to form a ceramic plate, FIG. 1D shows a step in which the ceramic plate is supported by a supporting sheet, FIG. 1E shows a step (3), in which the ceramic plate is cut with a cutting blade, FIG. 1F shows a step (6), in which the plurality of phosphor plates are transferred from the supporting sheet to a transfer sheet, and FIG. 1G shows a step in which an optical semiconductor device is produced.

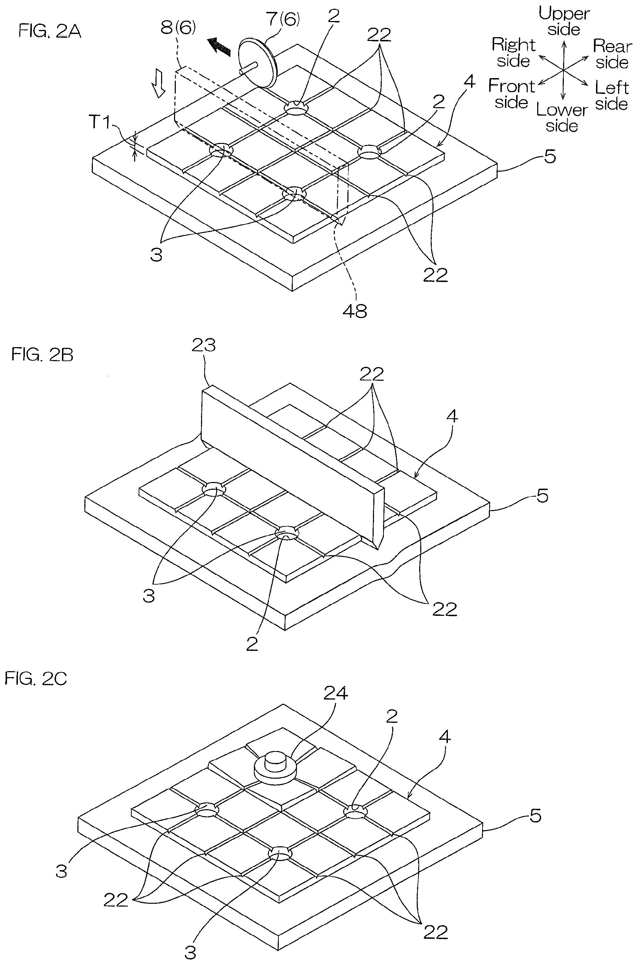

[FIG. 2] FIG. 2A to FIG. 2C are process diagrams illustrating a modified example of the step (3) shown in FIG. 1E, FIG. 2A showing a step in which the ceramic plate is scribed, FIG. 2B showing a step in which the ceramic plate is broken with a breaking member, and FIG. 2C showing a step in which the ceramic plate is broken with a grinding member.

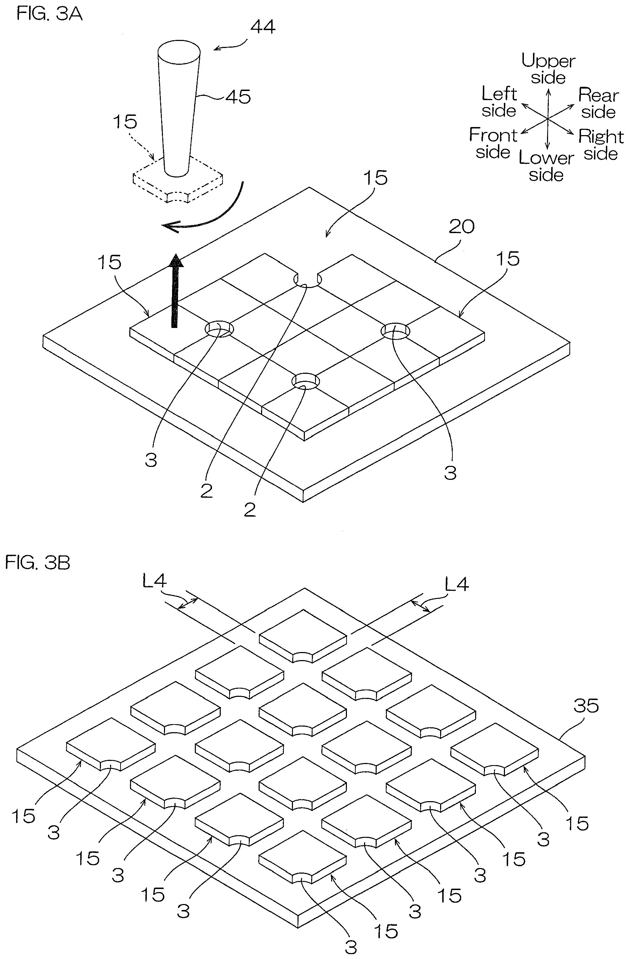

[FIG. 3] FIG. 3A and FIG. 3B are process diagrams illustrating a modified example of the step (6) shown in FIG. 1F, FIG. 3A showing a step in which the phosphor plate is taken off from the supporting sheet and turned, and FIG. 3B showing a step (7), in which the plurality of phosphor plates are arranged on a separate supporting sheet.

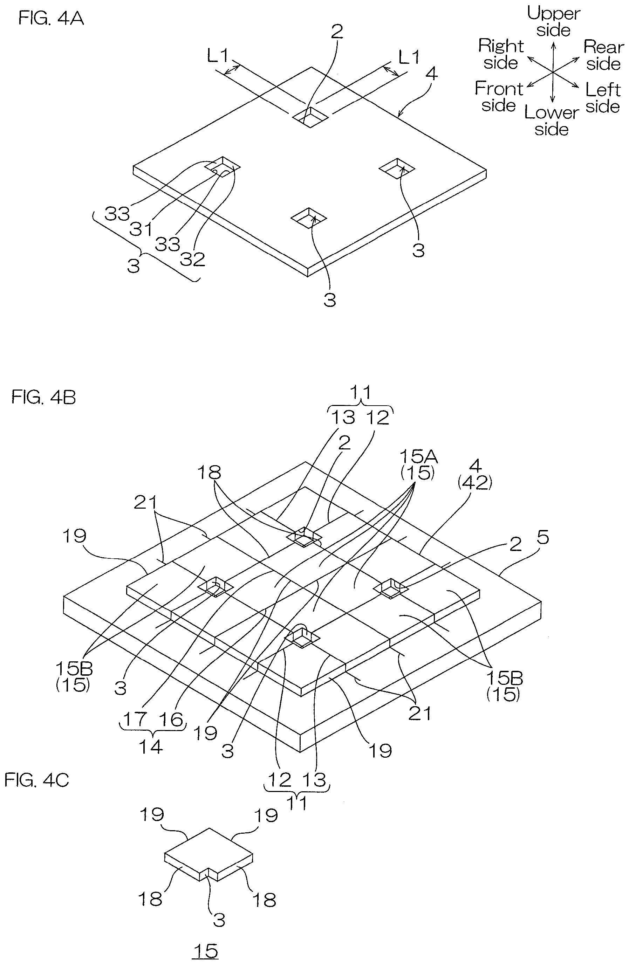

[FIG. 4] FIG. 4A to FIG. 4C are process diagrams illustrating a modified example of the step (2) and step (3) shown in shown in FIG. 1B, FIG. 1E, and FIG. 1F, FIG. 4A showing the step (2), in which square holes, and penetration faces having a front face, rear face, and two connection faces are formed in the greensheet, FIG. 4B showing the step (3), in which the ceramic plate is cut, and FIG. 4C showing a step in which the phosphor plate is obtained.

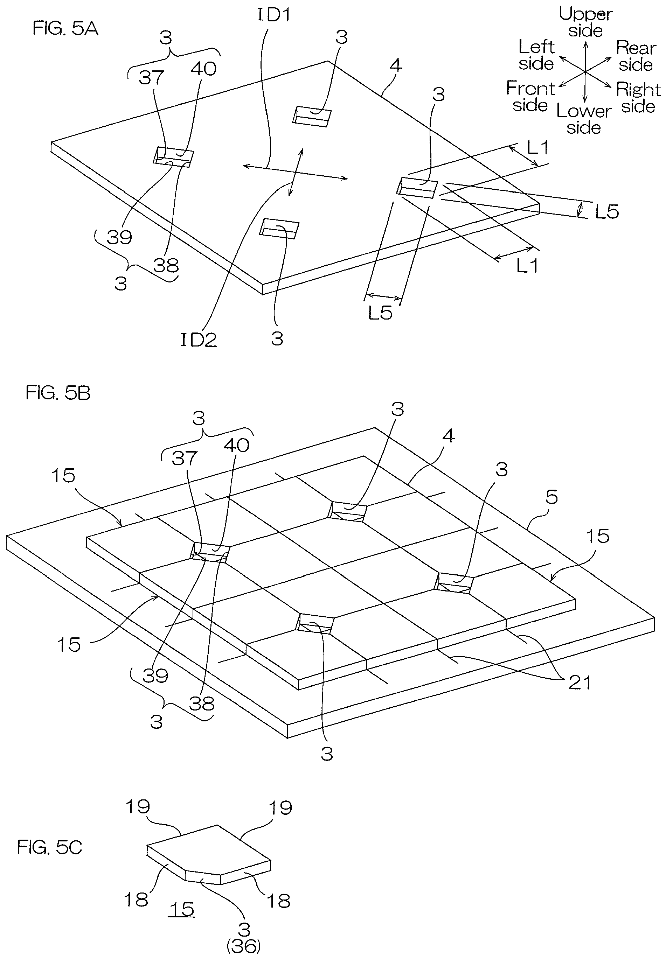

[FIG. 5] FIG. 5A to FIG. 5C are process diagrams illustrating a modified example of the step (2) and step (3) shown in FIG. 1B, FIG. 1E, and FIG. 1F, FIG. 5A showing the step (2), in which square holes, and penetration faces having a front left face, a rear right face, a front right face, and a rear left face are formed in the greensheet, FIG. 5B showing the step (3), in which the ceramic plate is cut, and FIG. 5C showing a step in which the phosphor plate is obtained.

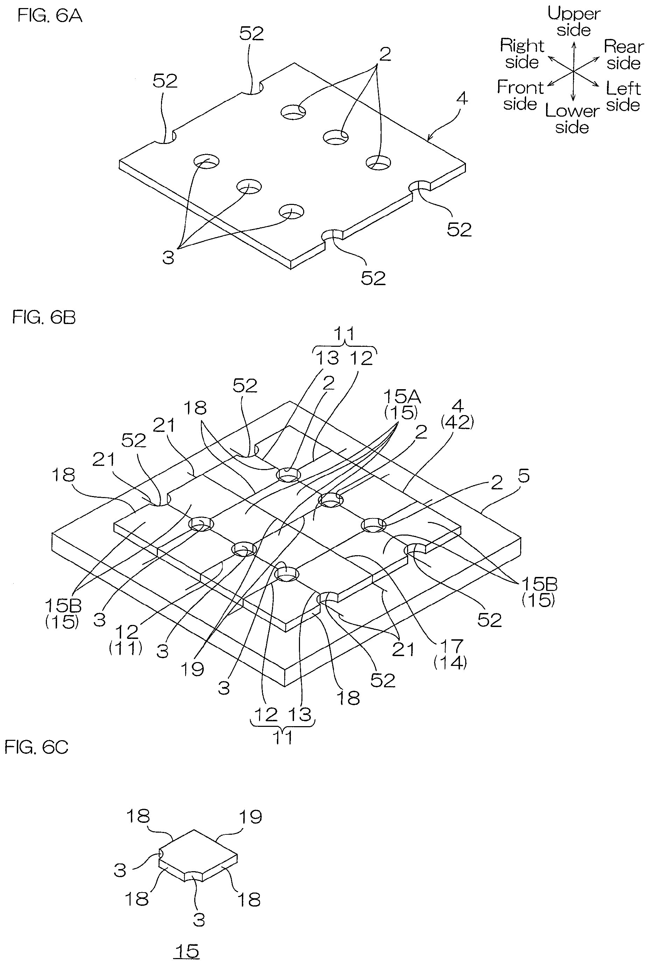

[FIG. 6] FIG. 6A to FIG. 6C are process diagrams illustrating a modified example of the step (2) and step (3) shown in FIG. 1B, FIG. 1E, and FIG. 1F, FIG. 6A showing a step (2), in which a plurality of through holes are formed in the greensheet, FIG. 6B showing a step (3), in which the ceramic plate is cut so that the second cutting line only has a second left-right cutting line, and FIG. 6C showing a step in which a phosphor plate having two penetration faces is obtained.

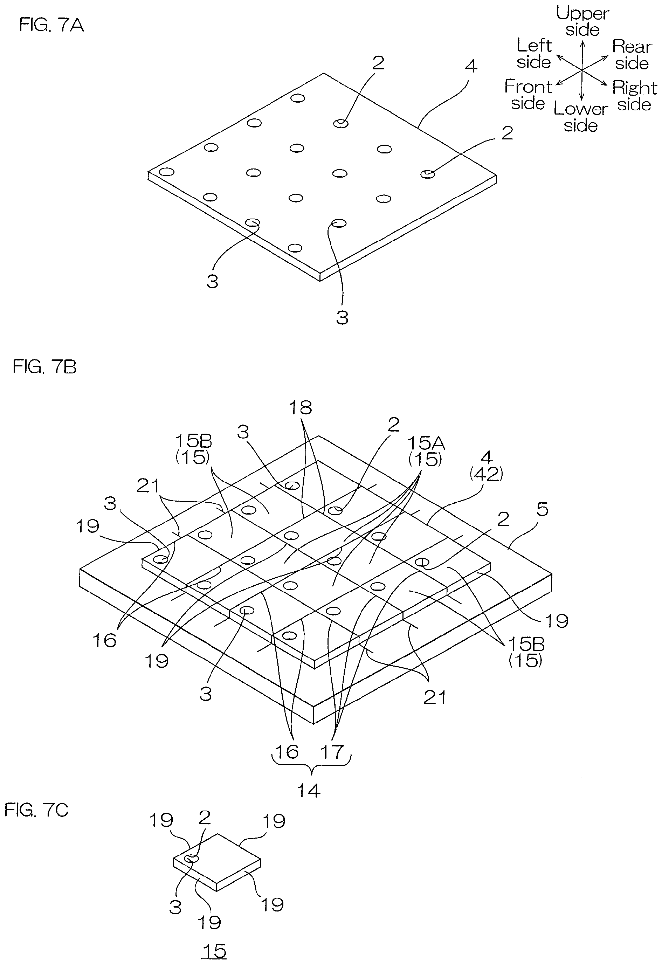

[FIG. 7] FIG. 7A and FIG. 7B are process diagrams illustrating a modified example of the step (2) and step (3) shown in FIG. 1B, FIG. 1E, and FIG. 1F, FIG. 7A showing a step (2), in which a plurality of through holes are formed in the greensheet, FIG. 7B showing a step (3), in which the ceramic plate is cut so that the second cutting line is not formed but only a first cutting line is formed, and FIG. 7C showing a step in which the phosphor plate having one through hole is obtained.

### DESCRIPTION OF EMBODIMENTS

### <An embodiment of method for producing a phosphor plate of the present invention>

An embodiment of the method for producing a phosphor plate of the present invention and the method for producing an optical semiconductor device are described with reference to FIG. 1A to FIG. 1G. In the figures, directions are in conformity with direction arrows.

### 1. Method for producing a phosphor plate

A method for producing a phosphor plate includes, in sequence, a step (1) (ref: FIG. 1A), in which a phosphor sheet of the present invention is prepared as a greensheet 1; a step (2) (ref: FIG. 1B), in which through holes 2 and penetration faces 3 fronting the through hole 2 are formed in the greensheet 1; a step (4) (ref: FIG. 1C), in which a phosphor plate of the present invention is formed as a ceramic plate 4 produced by calcining the greensheet 1; a step (3) (ref: FIG. 1D and FIG. 1E), in which the ceramic plate 4 is cut to form the plurality of phosphor plates 15 including the penetration faces 3; and a step (6) (ref: FIG. 1F), in which the phosphor plate 15 is transferred from the supporting sheet 5 to the transfer sheet 20.

That is, in the method for producing a phosphor plate, the step (1) (ref: FIG. 1A), step (2) (ref: FIG. 1B), step (4) (ref: FIG. 1C), step (3) (ref: FIG. 1D and FIG. 1E), and step (6) (ref: FIG. 1F) are carried out sequentially. Each of the steps is described below.

### 2. Step (1)

In the step (1), as shown in FIG. 1A, a greensheet 1 is prepared.

The greensheet 1 can be prepared by a method such as, slurry (slip) molding; compression molding such as cold isostatic pressing (CIP) and hot isostatic pressing (HIP); and injection molding. Preferably, in view of thickness precision of the greensheet 1, slurry molding and compression molding are used, more preferably, slurry molding is used.

In slurry molding, first, for example, a slurry containing a phosphor composition containing a phosphor material, organic particles, and a binder; and a dispersion medium is prepared.

The phosphor material is a raw material composing phosphor, and is suitably selected in accordance with the phosphor.

The phosphor has a function of converting wavelength, and examples thereof include yellow phosphor that can convert blue light to yellow light, and red phosphor that can convert blue light to red light.

Examples of the yellow phosphor include silicate phosphor such as (Ba,Sr,Ca)₂SiO₄;Eu and (Sr,Ba)₂SiO₄:Eu (barium orthosilicate (BOS)); garnet phosphor having a garnet crystal structure such as (Y,Gd,Ba,Ca,Lu)₃(Al,Si,Ge,B,P,Ga)₅O₁₂:Ce (YAG (yttrium • aluminum • garnet):Ce) and Tb₃Al₃O₁₂: Ce (TAG (terbium • aluminum • gamet):Ce); and oxynitride phosphor such as Ca-α-SiAlON. Examples of the red phosphor include nitride phosphors such as CaAlSiN₃:Eu and CaSiN₂:Eu. Preferably, garnet phosphor, more preferably YAG:Ce (Y₃Al₅O₁₂:Ce) is used.

Examples of the phosphor material include a metal itself that composes phosphor, a metal oxide thereof, and a metal nitride. To be specific, examples of the phosphor material include, when YAG: Ce is formed as the phosphor, metal oxides such as a yttrium-containing compound including yttrium oxide, an aluminum-containing compound including aluminum oxide, and a cerium-containing compound including cerium oxide are used. The phosphor material is formed, for example, into particles (or powder).

The phosphor material has a purity of, for example, 99.0 mass% or more, preferably 99.9 mass% or more.

The organic particles are contained in the phosphor composition as necessary to form micropores (not shown) in the ceramic plate 4. For the organic material forming the organic particles, those materials that are thermally decomposed completely in the step (4) (described later) are used, and thermoplastic resin such as acrylic resin (to be specific, polymethyl methacrylate), styrene resin, acryl-styrene resin, polycarbonate resin, benzoguanamine resin, polyolefin resin, polyester resin, polyamide resin, and polyimide resin; and thermosetting resin such as epoxy resin and silicone resin are used. Preferably, thermoplastic resin, more preferably, acrylic resin is used. The average particle size of the organic particles is not particularly limited, and for example, it is 3.4 µm or more, preferably 4.0 µm or more, and for example, 25.0 µm or less, preferably 20.0 µm or less, more preferably 8.0 µm or less.

The organic particle content relative to a total of the phosphor material content and the organic particles content is, for example, 1.5% by volume or more, preferably 2.0% by volume or more, and for example, 12.0% by volume or less, preferably 10.0% by volume or less, more preferably 8.0% by volume or less.

Examples of the binder include resin such as acrylic polymer, butyral polymer, vinyl polymer, and urethane polymer. Examples of the binder also include water-soluble binders. Preferably, acrylic polymer, more preferably, water-soluble acrylic polymer is used. The binder content is set so that relative to 100 parts by volume of a total of the phosphor material and the binder, the binder content is, for example, 10 parts by volume or more, preferably 20 parts by volume or more, more preferably 30 parts by volume or more, and for example, 60 parts by volume or less, preferably 50 parts by volume or less, more preferably 40 parts by volume or less.

The phosphor composition can further contain, for example, as necessary, additives such as a dispersing agent, a plasticizer, and a calcination auxiliary agent.

The dispersion medium is not particularly limited, as long as it can disperse the phosphor material and the organic particles. Examples of the dispersion medium include water, and an organic dispersion medium such as acetone, methyl ethyl ketone, methanol, ethanol, toluene, methyl propionate, and methyl cellosolve. Preferably, water is used. The dispersion medium content relative to the slurry is, for example, 1 mass% or more, for example, 30 mass% or less.

To prepare the slurry, first, the above-described component is blended at the above-described ratio, and the mixture is subjected to, for example, wet blending with a ball mill.

When the slurry is prepared, the above-described component can be subjected to wet blending all at once. Alternatively, the components other than the organic particles can be subjected to wet blending to prepare a first slurry, and then, the first slurry can be blended with organic particles by wet blending to prepare a slurry.

Then, in the step (1), the slurry is applied on the surface of the release sheet 10, and thereafter, dried.

The release sheet 10 is formed from a flexible material. Examples of such materials include a polyester sheet such as polyethylene terephthalate (PET) sheet; a polycarbonate sheet; polyolefin sheets such as a polyethylene sheet and a polypropylene sheet; a polystyrene sheet; an acryl sheet; and resin sheets such as a silicone resin sheet and a fluorine resin sheet. Furthermore, foil of metals such as copper foil and stainless steel foil are used. Preferably, a resin sheet, even more preferably, a polyester sheet is used. The surface of the release sheet 10 may be treated for release in order to improve releasability, as necessary. The thickness of the release sheet 10 is set suitably in view of handleability and costs, and is, to be specific, 10 µm or more and 200 µm or less.

The slurry is applied on the release sheet 10 by coating methods such as doctor blade coating, gravure coating, fountain coating, cast coating, spin coating, and roll coating.

In this manner, a coating composed of slurry is formed on the surface of the release sheet 10.

Then, the coating is dried.

The drying temperature is, for example, 20°C or more, preferably 50°C or more, and for example, 200°C or less, preferably 150°C or less.

The drying time is, for example, 1 minute or more, preferably 2 minutes or more, and for example, 24 hours or less, preferably 5 hours or less.

In this manner, the greensheet 1 supported by the release sheet 10 is obtained.

The greensheet 1 is a sheet before calcining the ceramic plate 4 (ref: FIG. 1C), and is a plate extending in front-back directions and left-right directions.

Thereafter, the release sheet 10 is released from the greensheet 1.

Thereafter, as necessary, to obtain a desired thickness, a plurality of (a plurality of layers of) greensheets 1 can be laminated by heat lamination to obtain a greensheet laminate 1.

The greensheet 1 (or greensheet laminate 1) has a thickness T1 of, for example, 10 µm or more, preferably 30 µm or more, and for example, 500 µm or less, preferably 200 µm or less.

### 3. Step (2)

In this step (2), as shown in FIG. 1B, through holes 2 are formed in the greensheet 1.

In the greensheet 1, the plurality of through holes 2 are arranged in line in front-back directions and left-right directions in spaced-apart relation to each other (2 rows in front-back directions and 2 rows in left-right directions). The plurality of through holes 2 are round holes that penetrates the greensheet 1 in the thickness direction (up-down direction).

The step (2) can be conducted by methods of making holes such as the following: for example, the greensheet 1 can be subjected to punching, blast processing, drilling, or laser processing with, for example, YAG laser.

For the blast processing, for example, direct pressure blast processing and siphon processing can be used. In blast processing, to be specific, in the greensheet 1, a resist is placed so as to cover the portions excluding the portions where through holes 2 are made, and then a blasting material is greensheet 1 is applied. The size of the through hole 2 is suitably adjusted by suitably adjusting the types and particle size of the blasting material used for blast processing, and the speed of blasting, or type (direct pressure ,siphon).

Blast processing is preferable in view of productivity, compared with laser processing.

To carry out the step (2), in view of shortening takt time and reducing processing costs, preferably, the greensheet 1 is punched or the greensheet 1 is drilled.

When the greensheet 1 is subjected to drilling, since a drill has a small diameter and easily damaged (broken), and therefore to prevent such problems, drilling process takes long time. Therefore, in view of shortening the takt time, more preferably, the greensheet 1 is punched.

Then, by forming the plurality of through holes 2 in the greensheet 1, a plurality of penetration faces 3 fronting of the plurality of through holes 2 are formed in the greensheet 1. That is, in the step (2), the through holes 2 and the penetration faces 3 are formed simultaneously.

The penetration face 3 are inner periphery of the through hole 2 extending in the thickness direction (up-down direction) in the greensheet 1.

The size of the through hole 2 and the penetration face 3 is suitably set in accordance with the size of the connection portion 25 and the wire 29 (ref: FIG. 1G) of the optical semiconductor device 30 described later. To be specific, the through hole 2 has an internal diameter L1 of, for example, 0.1 mm or more, preferably 0.3 mm or more, and for example, 5.0 mm or less, preferably 1.0 mm or less. The interval L2 between the through holes 2 that are adjacent in front-back directions and left-right directions is, for example, 0.5 mm or more, preferably 1.0 mm or more, and for example, 20 mm or less, preferably 10 mm or less. The pitch L3 of the through holes 2 that are adjacent to each other, that is, a sum of the internal diameter L1 and the interval L2 of the through hole 2 is, for example, 0.1 mm or more, preferably 1 mm or more, and for example, 20 mm or less, preferably 10 mm or less.

### 4. Step (4)

In the step (4), as shown in FIG. 1C, the greensheet 1 (ref: FIG. 1B) is calcined.

The calcination temperature is, for example, 1300°C or more, preferably 1500°C or more, and for example, 2000°C or less, preferably 1800°C or less.

The calcination time is, for example, 1 hour or more, preferably 2 hours or more, and for example, 24 hours or less, preferably 8 hours or less.

The speed of the temperature increase in calcination is, for example, 0.5°C/minutes or more, and 20°C/ minutes or less.

To subject the organic components such as a binder and a dispersing agent to thermal decomposition and to remove them, before the above-described calcination (main calcination), organic component removal processing can also be performed by preheating in air at, for example, 600°C or more and 1300°C or less using an electric furnace.

By calcination of the above-described greensheet 1, a ceramic plate 4 having the through holes 2 and penetration faces 3 is produced.

The ceramic plate 4 (ref: FIG. 1 C) after calcining shrinks compared with the greensheet 1 (FIG. 1B) before calcination. For example, the thickness T1, the internal diameter L1 of the through hole 2, interval L2 between the through holes 2 that are adjacent to each other, and pitch L3 between the through holes 2 that are adjacent to each other in the ceramic plate 4 after calcinations is, for example, 99% or less, preferably 95% or less, more preferably 90% or less, and 60% or more relative to T1, L1, L2 and L3 of the greensheet 1 before calcination.

To be specific, the ceramic plate 4 after calcination has a thickness T1 of, for example, 0.03 mm or more, preferably 0.05 mm or more, and for example, 1.0 mm or less, preferably 0.3 mm or less. The internal diameter L1 of the through hole 2 of the ceramic plate 4 after calcinations is, for example, 0.1 mm or more, and for example, 1.0 mm or less, preferably 0.5 mm or less. The interval L2 between the through holes 2 that are adjacent to each other in front-back directions and left-right directions in the ceramic plate 4 after calcination is, for example, 0.5 mm or more, preferably 1.0 mm or more, and for example, 20 mm or less, preferably 10 mm or less. The pitch L3 between the through holes 2 in the ceramic plate 4 after calcination is, for example, 0.6 mm or more, preferably 1.1 mm or more, and for example, 20.5 mm or less, preferably 10.5 mm or less.

In the ceramic plate 4, a plurality of micropores (not shown) are formed. The pores have an average pore size of, for example, 2.5 (µm or more, preferably 3.0 µm or more, more preferably 3.5 µm or more, and for example, 20.0 µm or less, preferably 16.0 µm or less, more preferably 10.0 µm or less.

### 5. Step (3)

In the step (3), as shown in FIG. 1D and FIG. 1E, the ceramic plate 4 is cut to form a plurality of phosphor plates including the penetration face 3.

In this step (3), as shown in FIG. 1D, first, the ceramic plate 4 is supported by the supporting sheet 5.

For the supporting sheet 5, a slightly adhesive dicing tape that can support the supporting sheet 5 to reliably cut the ceramic plate 4 and thereafter to release the ceramic plate 4 (to be specific, phosphor plate 15 described later) after cutting is used. The size of the supporting sheet 5 is suitably adjusted in accordance with the size of the ceramic plate 4, and for example, the length in front-back directions and the length in left-right directions of the supporting sheet 5 are longer relative to those of the ceramic plate 4.

Then, in the step (3), as shown in FIG. 1E, the greensheet 1 is cut with a cutting blade 6.

For the cutting blade, as shown in FIG. 1E, for example, a dicing saw (dicing blade) 7 having a disc shape and is rotatable around its axis, and for example, a cutter (not shown) having a generally horizontal edge is used. For the cutting blade 6, preferably, a dicing saw 7 is used.

To cut the ceramic plate 4, to be specific, for example, a dicing device including the dicing saw 7, and a cutting device (not shown) having a cutter is used. Preferably, a dicing device is used.

Then, the ceramic plate 4 is cut so that the first cutting line 11 as an example of cutting lines formed with the above-described cutting blade 6 pass through the plurality of through holes 2, thereby producing the phosphor plate 15. To be specific, the ceramic plate 4 is cut so that the penetration face 3 defining one through hole 2 is given to the plurality of phosphor plates 15 and one penetration face 3 is divided. To be specific, the ceramic plate 4 is cut so that the penetration face 3 defining one through hole 2 is given to four phosphor plates 15 and one penetration face 3 is divided into four.

To be specific, the ceramic plate 4 is cut so that the first cutting lines 11 pass through the centers of the plurality of through holes 2. Then, one penetration face 3 is divided into a plural number.

The first cutting line 11 has first front-back cutting lines 12 extending in front-back directions and arranged in left-right directions in spaced-apart relation to each other, and first left-right cutting lines 13 extending in left-right directions and arranged in front-back directions in spaced-apart relation to each other.

The first front-back cutting lines 12 and the first left-right cutting lines 13 orthogonally cross each other at the centers of the plurality of through holes 2.

Along with cutting of the ceramic plate 4 along the first cutting line 11, cutting of the ceramic plate 4 along the second cutting line 14 is performed.

The second cutting lines 14 do not pass the through holes 2. To be specific, the second cutting lines 14 pass between the through holes 2. The second cutting lines 14 have second front-back cutting lines 16 extending in front-back directions and are parallel and adjacent to the first front-back cutting lines 12, and second left-right cutting lines 17 extending in left-right directions and are parallel and adjacent to the first left-right cutting lines 13.

The second front-back cutting lines 16 and the first front-back cutting lines 12 are arranged alternatively in left-right directions at an equal interval. The second left-right cutting line 17 and the first left-right cutting line 13 are arranged alternatively in front-back directions at an equal interval.

The ceramic plate 4 is cut so that the lower end portion of the cutting blade 6 goes into the supporting sheet 5. Therefore, cutting grooves 21 corresponding to the first cutting lines 11 and the second cutting lines 14 are formed at the upper portion of the supporting sheet 5.

Then, by cutting the ceramic plate 4 along the above-described first cutting line 11 and the second cutting line 14, the plurality of phosphor plates 15 are produced while they are supported on the upper face of the supporting sheet 5.

The phosphor plate 15 has a plate shape having a flat upper face and a flat lower face. The side face of the phosphor plate 15 has a penetration face 3 divided (given) from one penetration face 3, two first side faces 18 (two faces) that are continuous with the end portion of the penetration face 3 and along the first cutting line 11, and two second side faces 19 (two faces) that are continuous with the end portion of the first side face 18 and along the second cutting line 14.

To be specific, in the first phosphor plate 15A (ref: hatched portion in FIG. 1E) that is positioned at the center (portion excluding the peripheral end portion to be described later) of the supporting sheet 5 and in which the penetration face 3 is formed at the rear left side face, the first side face 18 along the first front-back cutting line 12 is continuous with the front end portion of the penetration face 3, and the first side face 18 along the first left-right cutting line 13 is continuous with the rear end portion of the penetration face 3. The second side face 19 along the second front-back cutting line 16 is continuous with the right end portion of the first side face 18 between the first left-right cutting line 13, and the second side face 19 along the second left-right cutting line 17 is continuous with the front end portion of the first side face 18 along the first front-back cutting line 12, and the front end portion of the second side face 19 along the second front-back cutting line 16. The penetration face 3 of the phosphor plate 15 and the side faces of the first side face 18 and the second side face 19 are in continuous with each other in this way.

Meanwhile, the second phosphor plate 15B positioned at the peripheral end portion of the supporting sheet 5 has, at least, two first cutting lines 11 and one peripheral face corresponding to the peripheral face of the ceramic plate 4. The second phosphor plate 15B includes a plurality of (4) third phosphor plates 15B3 and a plurality of fourth phosphor plates 15B4. The third phosphor plate 15B3 is positioned at the corner portion of the supporting sheet 5, and two first cutting lines 11 (to be specific, one first front-back cutting line 12 and one first left-right cutting line 13) and two peripheral faces corresponding to the peripheral face of the ceramic plate 4. The fourth phosphor plate 15B4 is positioned between the third phosphor plates 15B3, and has two first cutting lines 11 and one second cutting line 14 (second front-back cutting line 16 or second left-right cutting line 17), and one peripheral face corresponding to the peripheral face of the ceramic plate 4.

The size of the plurality of phosphor plates 15 is suitably set in accordance with the size of the optical semiconductor element 28 (ref: FIG. 1G) to be described later. The phosphor plate 15 has a length in front-back directions and a length in left-right directions of, relative to the length in front-back directions and the length in left-right directions of the penetration face 3 (that is, half of the internal diameter L1 of through hole 2), for example, twice or more, preferably four times or more, and for example, 20 times or less, preferably 10 times or less. To be specific, the phosphor plate 15 has a length in front-back directions and a length in left-right directions of, for example, 0.1 mm or more, preferably 0.5 mm or more, and for example, 10 mm or less, preferably 2.0 mm or less.

### 6. Step (6)

In the step (6), as shown in FIG. 1F, the plurality of phosphor plates 15 are transferred from the supporting sheet 5 to the transfer sheet 20.

To transfer the plurality of phosphor plates 15 from the supporting sheet 5 to the transfer sheet 20, for example, first, the transfer sheet 20 is prepared, and the transfer sheet 20 is disposed on the plurality of phosphor plates 15 to face the phosphor plates.

The transfer sheet 20 can stretch in front-back directions and left-right directions (surface direction), and has slight adhesiveness. The size of the transfer sheet 20 is set suitably in accordance with the size of the plurality of phosphor plates 15, and has a longer length in front-back directions and length in left-right directions relative to a total of the length in front-back directions of the plurality of transfer sheets 20, and a total of the length in left-right directions of the plurality of transfer sheets 20.

Then, the lower face of the transfer sheet 20 is allowed to contact the upper face of the plurality of phosphor plates 15, and then, the plurality of phosphor plates 15 are removed from the supporting sheet 5. In this manner, the plurality of phosphor plates 15 are transferred from the supporting sheet 5 to the transfer sheet 20. That is, the plurality of phosphor plates 15 are temporarily fixed to the transfer sheet 20.

In this manner, the plurality of phosphor plates 15 are produced while temporarily fixed to the transfer sheet 20.

The phosphor plate 15 is not the optical semiconductor element 28 to be described in next FIG. 1G. The phosphor plate 15 is one component of the optical semiconductor device 30, that is, a component to produce the optical semiconductor device 30, and does not include the optical semiconductor element 28. The phosphor plate 15 is distributed singly as a component, and is an industrially applicable device, but is not thereto.

### 7. Step in which optical semiconductor device is produced

Thereafter, an optical semiconductor device 30 is produced using the phosphor plate 15.

To be specific, first, as shown in FIG. 1F, each of the plurality of phosphor plates 15 is taken off from the transfer sheet 20 with, for example, a pick-up device (not shown) including a collet, and then, as shown in FIG. 1G, piled on the upper face of the optical semiconductor element 28.

The optical semiconductor element 28 is included in the optical semiconductor device 30.

The optical semiconductor device 30 includes a substrate 26, a terminal 27, an optical semiconductor element 28, a phosphor plate 15, and a wire 29.

The substrate 26 has a generally plate shape, and is composed of an insulating material.

The terminal 27 is disposed on the upper face of the substrate 26.

The optical semiconductor element 28 is fixed on the upper face of the substrate 26, and is disposed in spaced-apart relation with the terminal 27. The optical semiconductor element 28 has a generally plate shape, and is composed of an optical semiconductor material. On the corner portion of the upper face of the optical semiconductor element 28, a connection portion 25 is formed.

The phosphor plate 15 is disposed on the upper face of the optical semiconductor element 28 so as to expose the connection portion 25. The phosphor plate 15 is allowed to adhere to the upper face of the optical semiconductor element 28 through an adhesive, that is not shown.

The wire 29 is disposed so that it is bent toward upper side. The wire 29 bends in generally letter U shape with its opening toward below. One end portion of the wire 29 is connected to the connection portion 25, and the other end of the wire 29 is connected to the terminal 27. That is, the wire 29 allows connection between the connection portion 25 and the wire 29 (wire bonding). The wire 29 is disposed to detour the phosphor plate 15.

To produce the optical semiconductor device 30, first, a substrate 26 in which a terminal 27 and an optical semiconductor element 28 are disposed is prepared. Then, the lower face of the phosphor plate 15 is allowed to adhere to the upper face of the optical semiconductor element 28 through an adhesive, which is not shown. At this time, the phosphor plate 15 is piled on the optical semiconductor element 28 so as to expose the connection portion 25 from the penetration face 3. Thereafter, the connection portion 25 is connected to the terminal 27 through the wire 29 (wire bonding).

The description above is an example, and for example, the method can be suitably and accordingly changeable. For example, the phosphor plate 15 and the optical semiconductor element 28 are joined, and thereafter they can be disposed to the substrate 26.

### 8. Operations and effects

With the method, without molding the bar shaped shaped-body as described in the method in Patent Document 1, as shown in FIG. 1A, first, the greensheet 1 is prepared, and then, as shown in FIG. 1B, through holes 2 are formed in the greensheet 1, and then, as shown in FIG. 1E, the ceramic plate 4 produced from the greensheet 1 is cut. Therefore, the through holes 2 can be formed easily, and the phosphor plate 15 can be produced with excellent production efficiency.

With the method, by cutting the ceramic plate 4 having the first cutting line 11, the penetration face 3 is divided to (4) so that the penetration face 3 defining one through hole 2 is given to a plurality of (4) phosphor plates 15. Thus, production efficiency is even more excellent.

In this method, the phosphor sheet composed of the greensheet 1 can be prepared, and the phosphor plate 15 composed of the ceramic plate 4 can be produced.

As shown in FIG. 1E, when the supporting sheet 5 has scrapes caused by cutting (not shown in FIG. 1E) and/or when the supporting sheet 5 has cutting grooves 21, in later steps, to be specific, when the phosphor plate 15 is taken off with a pick-up device, the scrapes and/or cutting groove 21 may give effects (for example, to taking off of the phosphor plate 15 with a pick-up device).

However, as shown in FIG. 1F, after the step (3), by transferring the plurality of phosphor plates 15 from the supporting sheet 5 to the transfer sheet 20, the above-described effects can be excluded.

When the method in which the ceramic plate 4 is cut with a cutting blade 6, the ceramic plate 4 can be reliably cut.

In the step (2), by carrying out any one of the following methods, the through holes 2 can be reliably formed in the greensheet 1 while achieving shortening of takt time and reduction of processing costs: a method in which the greensheet 1 is punched, a method in which the greensheet 1 is subjected to blast processing, a method in which the greensheet 1 is subjected to laser processing, and a method in which the greensheet 1 is subjected to drilling.

### 9. Modified Example

In Modified Examples, those members and steps that are the same as the embodiment above, the same reference numerals are given and detailed descriptions thereof are omitted.

### (1) Number of second front-back cutting line and second left-right cutting line

In one embodiment, as shown in FIG. 1E, the ceramic plate 4 is cut so that the second front-back cutting line 16 is singular, but for example, although not shown, the ceramic plate 4 can be cut so that the second front-back cutting line 16 is in a plural number. In the case of the above, in the step (2), the through holes 2 are arranged, for example, so that there are three or more left-right rows in the greensheet 1, and in the step (3), the second front-back cutting line 16 is formed between every two adjacent through holes 2 arranged in left-right directions.

In one embodiment, as shown in FIG. 1E, the ceramic plate 4 is cut so that the second left-right cutting line 17 is singular, but for example, although not shown, the ceramic plate 4 can be cut so that the second left-right cutting line 17 is in a plural number. In this case, in the step (2), the through holes 2 are arranged, for example, so that there are three or more front-rear rows in the greensheet 1, and in the step (3), the second left-right cutting line 17 is formed between every two adjacent through holes 2 in front-back directions.

### (2) Number of through hole

Although not shown, for example, the through hole 2 can be singular.

### (3) Number of division of the penetration face

In one embodiment, as shown in FIG. 1E, one penetration face 3 is divided into 4. However, the number of division of the penetration face 3 is not particularly limited. Although not shown, for example, it can be divided to 2, 3, 5, 6, or 7.

### (4) Method of cutting ceramic plate in the step (3)

In one embodiment, in the step (3), as shown in FIG. 1E, the ceramic plate 4 is cut with a cutting blade 6, but for example, as shown in FIG. 2A and FIG. 2B, the ceramic plate 4 can be scribed or broken.

In this method, first, as shown in FIG. 2A, the upper portion of the ceramic plate 4 is scribed (shaved) along the first cutting line 11 and the second cutting line 14.

To scribe the ceramic plate 4, the dicing saw 7 (ref: solid line) and the cutter 8 (ref: phantom line) are used. The cutter 8 has a cutting edge 48 that is movable in up-down direction. The cutting edge 48 is parallel to the upper face of the ceramic plate 4.

In this manner, the groove 22 corresponding to the first cutting line 11 and the second cutting line 14 are formed on the upper portion of the ceramic plate 4. The groove 22 has a cross section of generally V shape with its opening facing upward. The groove 22 has a depth of, for example, 1 µm or more, preferably 3 µm or more, and for example, 20 µm or less, preferably 10 µm or less.

Thereafter, as shown in FIG. 2B, the ceramic plate 4 is broken along with the groove 22.

To break the ceramic plate 4, a breaking member 23 sharpened downward is pressed against the groove 22, and the breaking member 23 is pressed downward.

Alternatively, as shown in FIG. 2C, while pressing the upper face of the ceramic plate 4 with a grinding member 24 having a flat lower face and a disc shape, the grinding member 24 is allowed to grind in front-back directions and left-right directions (grind breaking). Then, when the end portion of the lower face of the grinding member 24 is overlapped with the position of the groove 22, the pressured applied from the grinding member 24 is concentrated on the groove 22, and breaks the ceramic plate 4 (breaking) positioned below the groove 22.

In this manner, the ceramic plate 4 is broken along the groove 22.

Furthermore, instead of or in addition to cutting with a cutting blade, scribing, and breaking, the ceramic plate 4 can be cut by laser.

Examples of the laser include YAG laser and CO₂ laser, and preferably, YAG laser is used.

Alternatively, instead of or in addition to cutting with a cutting blade, scribing, and breaking, the ceramic plate 4 can be cut by blast processing.

Examples of blast processing include direct pressure blast processing and siphon processing. In blast processing, to be specific, in the ceramic plate 4, the portion other than the portion forming the first cutting line 11 and the second cutting line 14 is covered with a resist, and then a blasting material is applied to the ceramic plate 4. By suitably changing the types, particle size, blasting speed, and types (direct pressure, siphon) of the blasting material used in the blast processing, the size of the first cutting line 11 and the second cutting line 14 can be suitably adjusted.

Blast processing is preferable in view of productivity compared with laser processing.

In the step (3), of the following methods, i.e., a method in which the ceramic plate 4 is cut with a cutting blade, a method in which the ceramic plate 4 is scribed and broken, a method (laser processing) in which the ceramic plate 4 is cut by laser, and a method in which the ceramic plate 4 is subjected to blast processing, preferably, to prevent melting mark (to be specific, laser abrasion mark) to remain at the side face of the phosphor plate 15 caused by heat along with laser irradiation, preferably, the ceramic plate 4 is cut with a cutting blade, or the ceramic plate 4 is scribed or broken.

In the step (3), more preferably, in view of accuracy in size of the phosphor plate 15, the ceramic plate 4 is cut with a cutting blade.

### (5) Arrangement of the plurality of phosphor plates (arranging step (7))

In one embodiment, as shown in FIG. 1E and FIG. 1F, after the step (3), a step (6), in which a plurality of phosphor plates 15 are transferred from the supporting sheet 5 to the transfer sheet 20, is carried out. Instead, for example, as shown in FIG. 3A, a step (7), in which the plurality of phosphor plates 15 are taken off from the supporting sheet 5, and then as shown in FIG. 3B, the plurality of phosphor plates 15 are arranged so that the penetration faces 3 of the phosphor plate 15 are oriented in the same direction can be conducted.

In this method, first, as shown in FIG. 3A, the plurality of phosphor plates 15 are taken off from the supporting sheet 5 using a pick-up device 44, and then disposed on the surface of another supporting sheet 35.

The pick-up device 44 extends in up-down direction, and has a collet 45 having a suction port at its lower face. The collet 45 is configured to be rotatable around the axis extending in up-down direction. Then, the suction port of the collet 45 is allowed to contact the upper face of the phosphor plate 15 and to suck the phosphor plate 15, and then the phosphor plate 15 is pulled up, and thereafter, the collet is rotated to a desired angle (revolution). Thereafter, the plurality of phosphor plates 15 are arranged on the surface of another supporting sheet 35 so that the penetration face 3 of the plurality of phosphor plates 15 are oriented toward the same direction, for example, obliquely front-right side.

The plurality of phosphor plates 15 are arranged on the surface of another supporting sheet 35, with an interval L4 between each other in, for example, front-back directions and left-right directions.

Another supporting sheet 35 is formed from the same material as that of the supporting sheet 5.

Then, in this method, when the plurality of phosphor plates 15 are taken off from the supporting sheet 5 and the plurality of phosphor plates 15 are arranged so that their penetration faces 3 are oriented toward the same direction after the step (3), handleability of the plurality of phosphor plates 15 can be improved.

In the description above, the step (6) and the step (7) are carried out selectively, but the step (6) and the step (7) can be carried out both.

### (6) Formation of through hole

In one embodiment, in the step (2), as shown in FIG. 1B, the through holes 2 have a round shape, but the shape of the through hole 2 is not particularly limited. The through holes 2 can be formed, for example, into a polygon, to be specific, as shown in FIG. 4A and FIG. 5A, the through holes 2 can be formed into a rectangular shape. That is, the through holes 2 can be square holes.

As shown in FIG. 4A, the penetration face 3 fronting the through hole 2 has a front face 31 and a rear face 32 facing each other in front-back directions, and two connection faces 33 connecting their left-right both end portions. The front face 31 and the rear face 32 extend in left-right directions. The two connection faces 33 extend in front-back directions.

The length in front-back directions and length in left-right directions L1 of the through hole 2 are the same as the internal diameter L1 of the round hole in one embodiment.

In the step (3), as shown in FIG. 4B, by cutting the greensheet 1, the penetration face 3 is divided into a plurality of (4) phosphor plates 15.

Then, as shown in FIG. 4C, the phosphor plate 15 has a generally letter L shape when viewed from the top.

Alternatively, as shown in FIG. 5A, the penetration face 3 fronting the through hole 2 continuously has a front left face 37 and a rear right face 38 facing each other in a first inclination direction ID1, which inclines leftward as it approaches the front side, and a front right face 39 and a rear left face 40 connecting the front-back end portions of the front left face 37 and rear right face 38 and facing each other in a second inclination direction (direction which inclines rightward as it approaches the front side) ID2, which orthogonally crosses the first inclination direction ID1.

The length of the front left face 37 and the rear right face 38 (length along the first inclination direction ID2) L5 may be the same or different from the length of the front right face 39 and the rear left face 40 (length along the second inclination direction ID1) L5, and relative to the above-described L1, for example, 50% or more, preferably 65% or more, and for example, 200% or less, preferably 100% or less. To be specific, the L5 is, for example, 0.05 mm or more, preferably 0.1 mm or more, and for example, 5 mm or less, preferably 1 mm or less.

In the step (3), as shown in FIG. 5B, by cutting the greensheet 1, the front left face 37, rear right face 38, front right face 39, and rear left face 40 are given to a plurality of (4) phosphor plates 15.

Then, the phosphor plate 15 has a generally pentagon shape, and has an inclination face 36 formed from one of the front left face 37, rear right face 38, front right face 39, and rear left face 40.

### (7) Number of the penetration face in phosphor plate

In one embodiment, one phosphor plate 15 has one penetration face 3. However, the number of the penetration face 3 is not particularly limited. For example, as shown in FIG. 6C, one phosphor plate 15 may have a plurality of penetration faces 3.

In the step (2), as shown in FIG.6A, in the greensheet 1, the plurality of through holes 2 and cutouts 52 are arranged in line, 2 rows in front-rear (n rows) and 4 rows in left-right (2n rows). The cutouts 52 have a semicircle shape, in which the right side face or the left side face of the ceramic plate 4 is cut out.

Then, as shown in FIG. 6B, in the step (3), the ceramic plate 4 is cut so that two penetration faces 3 adjacent to each other in left-right directions are divided and given to at least one phosphor plate 15.

In this step (3), as shown in FIG. 6B, the second cutting line 14 does not have the second front-back cutting line 16 (ref: FIG. 1F), but only has a second left-right cutting line 17.

The phosphor plate 15 has, as shown in FIG. 6C, a plurality of (two) penetration faces 3. In the phosphor plate 15, two penetration faces 3 are connected by the first cutting line 11 (to be specific, first left-right cutting line 13). The two penetration faces 3 are disposed adjacent to each other in the phosphor plate 15 in the left-right directions.

### (8) Phosphor plate including through hole

In one embodiment, in the step (3), as shown in FIG. 1E, the ceramic plate 4 is cut so that the first cutting line 11 passes through the through hole 2. However, without limitation to the above, for example, as shown in FIG. 7B, the ceramic plate 4 can be cut so that only the second cutting line 14 passing between the through holes 2 adjacent to each other, not passing the through hole 2 can be formed without forming the first cutting line 11.

As shown in FIG. 7B, the second cutting line 14 passes between the adjacent through holes 2.

As shown in FIG. 7C, the phosphor plate 15 has a through hole 2 at an end portion (corner portion), and has a generally rectangular contour. One phosphor plate 15 includes one through hole 2.

### (9) B-stage composition sheet and C-stage cured sheet

In one embodiment, in the step (1), as shown in FIG. 1A, the phosphor sheet of the present invention is a greensheet containing phosphor 1, and in the step (4), as shown in FIG. 1C, the phosphor sheet of the present invention is a ceramic plate 4 produced by calcining the greensheet 1.

However, as shown in reference numeral in parenthesis in FIG. 1A, in the step (1), the phosphor sheet of the present invention can be a B-STAGE sheet 41 composed of a phosphor resin composition containing phosphor and thermosetting resin, and as shown in the reference numerals in parentheses in FIG. 1C, in the step (4), the phosphor sheet of the present invention can be a C stage sheet 42 produced by thermosetting the B-STAGE sheet 41.

The mixing ratio of the phosphor relative to the phosphor resin composition is, for example, 5 mass% or more, preferably 10 mass% or more, and for example, 80 mass% or less, preferably 70 mass% or less.

Examples of the thermosetting resin include 2-stage reaction curable resin and 1-stage reaction curable resin.

The 2-stage reaction curable resin has two reaction mechanisms, and in the first stage reaction, A-stage state can be changed into B-stage state (semicured), and then, in the second stage reaction, B-stage state can be changed into C-stage state (completely cured). That is, the 2-stage reaction curable resin is a thermosetting resin that can be brought into B-stage state with suitable heating conditions. The B-stage state is a state in which the thermosetting resin is in between the liquid A stage state and completely cured C stage state. In this state, curing and gelation progress slightly in the thermosetting resin, and the thermosetting resin is in semisolid or solid state having a compressive modulus smaller than the modulus of elasticity of C stage state resin.

The 1-stage reaction curable resin has one reaction mechanism, and in the first stage reaction, the status changes from A stage status to C stage status (completely cured). Such 1-stage reaction curable resin is a thermosetting resin in which reaction stops in the middle of the first stage reaction, and which can be brought into B-stage state from A stage state. With further reaction thereafter, the first reaction restarts and the thermosetting resin can be brought into C stage (completely cured) from B-stage state. That is, the thermosetting resin is a thermosetting resin that can be brought into B-STAGE state. Therefore, the 1-stage reaction curable resin cannot be controlled to stop the reaction in the middle of the first stage, that is, cannot be brought into B-STAGE state, and does not include curable resin that can be brought into C stage state (completely cured) all at once from A stage state.

In sum, the thermosetting resin is a thermosetting resin that can be brought into B-STAGE state.

Examples of the thermosetting resin include silicone resin, epoxy resin, urethane resin, polyimide resin, phenol resin, urea resin, melamine resin, and unsaturated polyester resin. For the thermosetting resin, preferably, silicone resin, and epoxy resin are used, more preferably, silicone resin, even more preferably, phenyl silicone resin is used. The above-described thermosetting resin can be the same type or a plurality of different types can be used.

The mixing ratio of the thermosetting resin is the remaining portion of the phosphor.

In the step (1), first, the phosphor resin composition is prepared. To prepare the phosphor resin composition, the above-described phosphor is blended with the thermosetting resin, thereby preparing varnish of the phosphor resin composition.

Then, the varnish is applied on the surface of the release sheet 10. Thereafter, the phosphor resin composition is heated (baked). The B-STAGE sheet 41 is prepared in this manner.

Thereafter, the B-STAGE sheet 41 is taken off from the release sheet 10.

Then, as shown in FIG. 1B, the step (2) is curried out. Preferably, the greensheet 1 is punched, or the greensheet 1 is drilled.

Thereafter, as shown in FIG. 1C, in the step (4), the B-stage sheet 41 is thermally cured. A C stage sheet 42 is produced.

### (10) Timing of step (4)

In one embodiment, as shown in FIG. 1B to FIG. 1E, the step (2) and the step (4) are carried out in sequence. That is, first, as shown in FIG. 1B, through holes 2 are formed in the greensheet 1, and thereafter, as shown in FIG. 1C, the greensheet 1 is a ceramic plate 4.

However, although not shown, the step (4) and the step (2) can be carried out in sequence. That is, although not shown, first, the greensheet 1 is a ceramic plate 4, and then, the through holes 2 are formed in the ceramic plate 4.

At this time, in the step (2), the through holes 2 can be formed in the ceramic plate 4 by, for example, in one embodiment, through holes 2 are formed in the greensheet 1, and preferably, blast processing and laser processing are used. These may be used singly, or may be used in combination. With blast processing or laser processing, through holes 2 and penetration faces 3 can be reliably formed in a hard ceramic plate 4.

Blast processing is preferable compared with laser processing, in view of productivity. Examples

The specific numeral values such as mixing ratio (content), physical property values, and parameters used in the following description can be replaced with upper limit value (numeral values defined with "or less", "less than") or lower limit value (numeral values defined with "or more", "more than") of corresponding mixing ratio (content), physical property values, and parameters in the above-described "DESCRIPTION OF EMBODIMENTS".

### Example 1

### <Step (1)>

A phosphor material powder composed of 11.34 g of yttrium oxide particles (purity 99.99%, manufactured by Nippon Yttrium Co., Ltd.), 8.577 g of aluminum oxide particles (purity 99.99%, manufactured by Sumitomo Chemical Co., Ltd.), and 0.087 g of cerium oxide particles was prepared.

Then, 20 g of the phosphor material powder was mixed with water-soluble binder ("WB4101 ", manufactured by Polymer Inovations, Inc) so that the solid content volume ratio was 62:38, and distilled water was added thereto. The mixture was put into an alumina-made vessel, and subjected to wet blending with zirconia balls with a diameter of 3 mm for 24 hours in a ball mill, thereby preparing a first slurry.

Then, organic particles (polymethyl methacrylate, average particle size 3.5 µm) were added to the first slurry so that the organic particles relative to a total of the phosphor material and organic particles was 3.0% by volume. The mixture was further subjected to wet blending, thereby preparing a slurry.

Then, as shown in the phantom line and solid line in FIG. 1A, the slurry was applied on the surface of the release sheet 10 composed of a PET sheet by doctor blade method, and dried at 70°C for 5 minutes, thereby producing a greensheet 1 having a thickness of 55 µm.

Thereafter, the greensheet 1 was removed from the PET sheet, and then the greensheet 1 was cut into a size of 20 mm × 20 mm. Two greensheets 1 after cutting were piled, and they were subjected to heat lamination using a hot press, thereby producing a greensheet laminate 1 having a thickness of 110 µm.

### <Step (2)>

As shown in FIG. 1B, a plurality of through holes 2 and a plurality of penetration faces 3 were formed in the greensheet laminate 1. To be specific, the greensheet laminate 1 was drilled with a NC drill machine having a drill with a diameter of 0.7 mm manufactured by Via Mechanics, Ltd., thereby making holes in the greensheet laminate 1.

In this manner, through holes 2 having a round shape, an internal diameter L1 of 0.7 mm, an interval L2 of 1.7 mm, and a pitch L3 of 2.4 mm were formed in the greensheet laminate 1.

### <Step (4)>

The greensheet laminate 1 was heated (preheating) in an electric muffle furnace in air at a temperature increase speed of 2°C/min to 1200°C, thereby thermally decomposing and removing the water-soluble binder and organic particles.

Thereafter, the greensheet laminate 1 was transferred to a high temperature furnace, heated under reduction atmosphere at a temperature increase speed of 5°C/min to 1800°C, and calcined at the temperature for 5 hours, thereby producing a ceramic plate 4 having a thickness of 120 µm as shown in FIG. 1C.

The ceramic plate 4, i.e., after calcination, shrank about 16% relative to the greensheet laminate 1, i.e., before calcination, to be specific, the through holes 2 in the calcined ceramic plate 4 had an internal diameter L1 of 0.6 mm, and the interval L2 between adjacent through holes 2 was 1.4 mm.

### <Step (3)>

Thereafter, as shown in FIG. 1D, the ceramic plate 4 was temporarily fixed to the surface of the supporting sheet 5 of dicing tape.

Then, they were set in a dicing device having a dicing saw 7, and as shown in FIG. 1E, cut with a dicing saw 7 having a blade thickness of 100 µm to pass through the center of the through hole 2.

For the dicing device, DFD 6361 manufactured by Disco Corporation was used.

### <Step (6)>

Thereafter, as shown in FIG. 1F, the plurality of phosphor plates 15 were transferred from the supporting sheet 5 to the transfer sheet 20 (temporarily fixed).

In this manner, the plurality of phosphor plates 15 fixed temporarily onto the transfer sheet 20 were produced.

### Example 2

A plurality of phosphor plates 15 were produced in the same manner as in Example 1, except that holes were made in the greensheet laminate 1 in the step (2) by, instead of drilling, subjecting the greensheet laminate 1 to laser processing.

In the laser processing, Model 5330 UV-YAG laser manufactured by Electro Scientific Industries, Inc. was used.

### Example 3

A plurality of phosphor plates 15 were produced in the same manner as in Example 1, except that holes were made in the greensheet laminate 1 by punching the greensheet laminate 1 instead of drilling in the step (2).

In the punching, a punching machine of MP series manufactured by UHT Corporation was used.

### Example 4

A plurality of phosphor plates 15 were produced in the same manner as in Example 1, except that holes were made in the greensheet laminate 1 by punching the greensheet laminate 1 instead of drilling, and the shape of the through holes 2 was changed from the round shape to the rectangular shape shown in FIG. 5A in the step (2).

In the punching, MP series manufactured by UHT Corporation were used.

The penetration face 3 having front left face 37, rear right face 38, front right face 39, and rear left face 40 was fronting the through hole 2.

The through hole 2 had a length in front-back directions (diagonal length) and a length in left-right directions (diagonal length) L1 of 1.0 mm, and the length of the front left face 37 and the rear right face 38, and the length of the front right face 39 and the rear left face 40 are 0.7 mm or more.

### Example 5

A plurality of phosphor plates 15 were produced in the same manner as in Example 1, except that a laser processing device was used instead of dicing device, the ceramic plate 4 was cut by subjecting the ceramic plate 4 to laser processing in the step (3).

For the laser processing device, Model 5330 UV-YAG laser manufactured by Electro Scientific Industries, Inc. was used.

### Evaluation

Step (2) and step (3) were evaluated in the following manner, and the results are shown in Table 1.

### 1. Evaluation of step (2)

The production of holes in the greensheet laminate 1 in the step (2) was evaluated based on the criteria below.
Excellent: No burrs and melting mark were found at the penetration face 3, and the through holes 2 having a desired size were formed, and the time taken to form four through holes 2 was less than 2 seconds, and the speed of making holes was fast.
Good: No burrs and melting mark were observed at the penetration face 3, and the through holes 2 having a desired size were formed. However, it took 5 seconds or more to form four through holes 2, and the speed of making holes was slow.
Not good: It took less than 5 seconds to form four through holes 2, and the speed of making holes was fast. However, burrs and melting mark were observed in the penetration face 3, and through holes 2 with a desired size could not be formed.

### 2. Evaluation of step (3)

Cutting of the ceramic plate 4 in the step (3) was evaluated based on the following criteria.
Excellent: No burrs and melting mark were observed in the first cutting line 11 and the second cutting line 14, and the phosphor plate 15 having a desired size was produced.
Good: Some burrs and melting mark were observed in the first cutting line 11 and the second cutting line 14.

**Table 1**

| | | Example 1 | Example 2 | Example 3 | Example 4 | Example 5 |
|---|---|---|---|---|---|---|
| | | FIG. 1A to FIG. 1F | FIG. 1A to FIG. 1F | FIG. 1A to FIG. 1F | FIG. 5A to FIG. 5C | FIG. 1A to FIG. 1F |
| Step (2) | Method | Drilling | Laser processing | Punching | Punching | Drilling |
| | | Device name: NC drilling machine manufactured by Via Mechanics, Ltd. | Device name: Model 5330 manufactured by Electro Scientific Industries, Inc. UV-YAG laser | Device name: MP series manufactured by UHT Corporation | Device name: MP series manufactured by UHT Corporation | Device name: NC drilling machine manufactured by Via Mechanics, Ltd. |
| | Evaluation | Good | Not good | Excellent | Excellent | Good |
| Step (3) | Method | Dicing | Dicing | Dicing | Dicing | Laser processing |
| | | Device name: DFD 6361 manufactured by Disco Corporation | Device name: DFD 6361 manufactured by Disco Corporation | Device name: DFD 6361 manufactured by Disco Corporation | Device name: DFD 6361 manufactured by Disco Corporation | Model 5330 manufactured by Electro Scientific Industries, Inc. UV-YAG laser |
| | Evaluation | Excellent | Excellent | Excellent | Excellent | Good |

While the illustrative embodiments of the present invention are provided in the above description, such is for illustrative purpose only and it is not to be construed as limiting in any manner. Modifications and variations of the present invention that will be obvious to those skilled in the art are to be covered by the following claims.

### Industrial Applicability

The phosphor plate produced with the method for producing a phosphor plate is used for production of an optical semiconductor device.

### Description of reference numeral

1 greensheet (greensheet laminate)
2 through hole
3 penetration face
4 ceramic plate
5 supporting sheet
6 cutting blade
9 phosphor plate
11 first cutting line
12 first front-back cutting line
13 first left-right cutting line
15 phosphor plate
20 transfer sheet
23 breaking member
24 grinding member

## Claims

1. A method for producing a phosphor plate, the method including the steps of, in sequence:
a step (1), in which a phosphor sheet is prepared,
a step (2), in which through holes and penetration faces fronting the through holes are formed in the phosphor sheet, and
a step (3), in which the phosphor sheet is cut to form a plurality of phosphor plates including the penetration faces.

2. The method for producing a phosphor plate according to Claim 1, wherein
in the step (3), the phosphor sheet is cut so that the cutting line passes through the through holes, and by cutting the phosphor sheet, the penetration face is divided so that the penetration face defining one through hole is given to the plurality of phosphor plates.

3. The method for producing a phosphor plate according to Claim 1, wherein
in the step (1), the phosphor sheet is a greensheet containing phosphor, and
a step (4), in which the phosphor sheet is a ceramic plate produced by calcining the greensheet, is further included after the step (2) and before the step (3).

4. The method for producing a phosphor plate according to Claim 3, further including,
a step (5), in which the ceramic plate is supported by a supporting sheet after the step (4) and before the step (3), and
a step (6), in which the plurality of phosphor plates are transferred from the supporting sheet to a transfer sheet after the step (3), and/or, a step (7), in which the plurality of phosphor plates are taken off from the supporting sheet, and the plurality of phosphor plates are arranged so that the penetration faces are oriented toward the same direction, after the step (3).

5. The method for producing a phosphor plate according to Claim 1, wherein
in the step (3), at least one of the following methods is conducted:
a method in which the phosphor sheet is cut with a cutting blade,
a method in which the phosphor sheet is scribed and broken,
a method in which the phosphor sheet is cut by laser, and
a method in which the phosphor sheet is cut by blast processing.

6. The method for producing a phosphor plate according to Claim 1, wherein
in the step (2), one of the following methods is conducted:
a method in which the phosphor sheet is punched,
a method in which the phosphor sheet is subjected to blast processing,
a method in which the phosphor sheet is subjected to laser processing, and
a method in which the phosphor sheet is subjected to drilling.

7. The method for producing a phosphor plate according to Claim 1, wherein
in the step (1), the phosphor sheet is a greensheet containing phosphor, and
a step (4), in which the phosphor sheet is a ceramic plate produced by calcining the greensheet, is further included after the step (1) and before the step (2).

8. The method for producing a phosphor plate according to Claim 7, wherein
in the step (2), one of the following methods is conducted:
a method in which the ceramic plate is subjected to blast processing, and
a method in which the ceramic plate is subjected to laser processing.
